(19) **Europäisches Patentamt**

**European Patent Office**

**Office européen des brevets**

(11) **EP 1 646 059 A2**

(12) **EUROPEAN PATENT APPLICATION**

(43) Date of publication:
**12.04.2006 Bulletin 2006/15**

(51) Int Cl.:
***H01G 9/20*** (2006.01)   ***H01L 51/46*** (2006.01)

(21) Application number: **04257383.2**

(22) Date of filing: **29.11.2004**

(84) Designated Contracting States:
**AT BE BG CH CY CZ DE DK EE ES FI FR GB GR HU IE IS IT LI LU MC NL PL PT RO SE SI SK TR**
Designated Extension States:
**AL HR LT LV MK YU**

(30) Priority: **06.10.2004 KR 2004079402**

(71) Applicant: **Korea Institute of Science and Technology**
**Seoul 136-130 (KR)**

(72) Inventors:
 • **Kang, Yong Soo**
  **Sungbuk-ku**
  **136-120 Seoul (KR)**

 • **Jung, Bum Suk**
  **136-130 Seoul (KR)**
 • **Kim, Young Jin**
  **Sungbuk-ku**
  **136-130 Seoul (KR)**
 • **Kang, Moon Sung**
  **121-828 Seoul (KR)**

(74) Representative: **Humphreys, Ceris Anne**
  **Abel & Imray**
  **20 Red Lion Street**
  **London WC1R 4PQ (GB)**

(54) **Highly efficient counter electrode for dye-sensitized solar cell and method of producing the same**

(57) Disclosed herein is a counter electrode for a dye-sensitized solar cell, and a method of producing the same. In the dye-sensitized solar cell includes a photoelectrode (10) containing a photosensitive dye molecules. The counter electrode (20) is positioned opposite to the photoelectrode (10), and an electrolytic solution (30) interposed between the photoelectrode (10) and the counter electrode (20). The counter electrode (20) has an electron transfer layer. The electron transfer layer has a structure in which one or more conductive materials, selected from the group consisting of a conductive polymer, platinum nanoparticles, a carbon compound, inorganic oxide particles, and a conductive polymer blend, are sequentially laminated. In the counter electrode (20), the electron transfer layer promotes smooth electron transfer through an interface between the electrolyte, containing pairs of redox ions, and counter electrode (20). Thereby, energy conversion efficiency is significantly improved in comparison with a conventional dye-sensitized solar cell employing a counter electrode in which only a platinum layer is applied on a transparent conductive material.

【FIG. 2】

## Description

### 1. Field of the Invention

The present invention relates to a counter electrode for a dye-sensitized solar cell and a method of producing the same. More particularly, the present invention pertains to a counter electrode for a dye-sensitized solar cell which includes a photoelectrode containing a photosensitive dye molecules, in which the counter electrode is positioned opposite to the photoelectrode, and an electrolytic solution interposed between the photoelectrode and the counter electrode, and a method of producing the same. At this time, the counter electrode has an electron transfer layer. The electron transfer layer has a structure in which one or more conductive materials, selected from the group consisting of a conductive polymer, platinum nanoparticles or a thin platinum film, a carbon compound, inorganic oxide particles, and a conductive polymer blend, are sequentially laminated.

### 2. Description of the Related Art

A representative example of conventional dye-sensitized solar cells is a solar cell known in 1991 by Gratzel et al. in Switzerland (U.S. Pat. Nos. 4,927,721 and 5,350,644). The solar cell suggested by Gratzel et al. is a photo-electrochemical solar cell employing an oxide semiconductor, which includes photosensitive dye molecules and titanium dioxide nanoparticles, and has the advantage of a production cost lower than a conventional silicone solar cell. However, it is problematic in that it is difficult to produce a solar cell having high energy conversion efficiency.

Additionally, U.S. Pat. Nos. 5,350,644 and 6,479,745 disclose production of a solar cell, which mostly relates to an improvement in a photoelectrode and an electrolyte. In a counter electrode according to the above patents, a platinum layer is laminated on a conductive substrate through a thermal decomposition process.

Korean Patent Registration No. 433630 discloses a dye-sensitized solar cell including a semiconductor electrode made of nanoparticle oxide, and a method of producing the same, in which an electronic structure and a surface characteristic of nanoparticle oxide, or a composition of an electrolyte, are changed to increase the voltage, thereby improving energy conversion efficiency.

A typical dye-sensitized nanoparticle oxide solar cell includes a nanoparticle oxide semiconductor cathode, a platinum anode, a dye applied on the cathode, and a redox liquid electrolyte employing an organic solvent or an alternative polymer electrolyte.

However, the dye-sensitized solar cell employing the liquid electrolyte is disadvantageous in that light conversion efficiency is less than about 8 - 9 % (@ 100 mW/cm$^2$) which is lower than that of a commercial silicon solar cell (about 12 - 16 % @ 100 mW/cm$^2$).

Furthermore, development of a flexible dye-sensitized solar cell employing a polymer electrode instead of a conductive glass substrate has attracted considerable attention throughout the world lately. However, the flexible dye-sensitized solar cell has very low light conversion efficiency, and thus, it has not yet been able to be commercialized.

If efficiency of the dye-sensitized solar cell is improved by about 4 - 5 %, a low production cost and efficiency ranking next to the silicon solar cell are possible, resulting in the significantly increased possibility of commercialization of the dye-sensitized solar cell. Accordingly, much effort has been made to improve the light conversion efficiency of the dye-sensitized solar cell throughout the world.

To improve the light conversion efficiency of the dye-sensitized solar cell, it is required to develop a photoelectrode, containing a titanium oxide ($TiO_2$) layer on which a dye is adsorbed, a liquid or gel/solid electrolyte, and a counter electrode on which a platinum catalyst is laminated.

Up to now, studies of the photoelectrode and electrolyte have mostly been made to improve the efficiency of the dye-sensitized solar cell.

Particularly, studies of the photoelectrode have frequently been made, and may usually be classified into the development of a low-priced and highly efficient dye, the optimization of photochemical characteristics of a titanium oxide layer (crystalline structure, morphology and the like), and the prevention of a charge recombination.

Currently, the studies of the electrolyte have mainly been conducted toward the application of an imidazolium-based ionic liquid and development of a gel/solid electrolyte. In a dye-sensitized solar cell including a conventional liquid electrolyte, an electrolyte solvent is likely to become volatilized from the solar cell when an external temperature of the solar cell increases due to sunlight. Therefore, the development of a solar cell which employs the gel/solid polymer electrolyte having no solvent is being pursued with keen interest to overcome the problems of the dye-sensitized solar cell having the conventional liquid electrolyte, such as efficiency reduction caused by a solvent leak.

Unlike the studies of the photoelectrode and electrolyte, a study of the counter electrode, on which a platinum catalyst is laminated, has attracted relatively little attention. The reason is that the mechanisms of electron and ion movement in the dye-sensitized solar cell are not yet known, and thus, the role of the counter electrode is not clearly undertook.

The studies of the counter electrode began recently. For example, Hauch and Georg laminated a platinum catalyst layer on a conductive glass substrate using various methods, and evaluated efficiencies (A. Hauch and A. Georg, Electrochimica Acta 46, 3457, 2001). They laminated platinum catalyst layers having various thicknesses on the conductive glass substrates using a DC magnetron sputtering method, an electron beam evaporation method, and a thermal decomposition method, and measured electron transfer resistance through an interface between an electrolyte and an electrode using AC impedance analysis. From the test results, it could be seen that the electron transfer from I- ions to the platinum layers is the determining step of a reaction rate on a surface of the counter electrode of the dye-sensitized solar cell.

Furthermore, Shibata et al. suggested a counter electrode which employs a conductive polymer, having an affinity for a gel electrolyte, instead of platinum, so as to improve the light conversion efficiency of a dye-sensitized solar cell using the gel electrolyte (Y. Shibata et al., Chem. Commun. 2730, 2003). They used the conductive polymer (poly (3,4-ethylenedioxy-thiophene)), which was doped with polystyrene sulfonate (PEDOT-PSS), instead of a conventional platinum catalyst layer, as the material for the counter electrode. From the test results, it could be seen that the use of the conductive polymer as the material for the counter electrode improves the light conversion efficiency of the gel electrolyte dye-sensitized solar cell in comparison with the use of the platinum catalyst. It is believed that this result is caused by a smooth electron transfer due to an improvement in contact between the gel electrolyte and counter electrode.

However, studies of the counter electrode for the dye-sensitized solar cell remain incomplete. Particularly, there remains a need to study a reaction area between the counter electrode and electrolyte, and develop a material capable of efficiently reducing electron transfer resistance through an interface between them so as to improve the efficiency of the dye-sensitized solar cell.

The present inventors have conducted studies into the lamination of an electron transfer promotion layer on a conventional platinum catalyst layer to increase a specific surface area of a counter electrode, resulting in the finding that electron transfer resistance is significantly reduced in comparison with a conventional counter electrode, thereby accomplishing the present invention.

SUMMARY OF THE INVENTION

Accordingly, an object of the present invention is to provide a highly efficient counter electrode for a dye-sensitized solar cell, which provides a large reaction area and efficiently reduces interfacial electron transfer resistance, and a method of producing the same.

In order to accomplish the above object, the present invention provides a counter electrode for a dye-sensitized solar cell which includes a photoelectrode containing a photosensitive dye molecules, in which the counter electrode is positioned opposite to the photoelectrode, and an electrolytic solution interposed between the photoelectrode and the counter electrode. The counter electrode is coated with an electron transfer layer which acts as a reduction catalyst. Additionally, the counter electrode includes one or more conductive materials selected from the group consisting of a conductive polymer, platinum nanoparticles or a thin platinum film, a carbon compound, and inorganic oxide particles.

In the counter electrode for the dye-sensitized solar cell according to the present invention, it is preferable that the substrate of the counter electrode be selected from a conductive glass, a conductive flexible polymer sheet, or a thin platinum film.

In the counter electrode for the dye-sensitized solar cell according to the present invention, it is preferable that the conductive polymer have an excellent affinity for an electrolyte, and be selected from the group consisting of poly [2-methoxy-5-(2'-ethylhexyloxy)-1,4-phenylenevinylene], polyaniline, polypyrrole, poly[3-tetradecylthiopene], poly [3,4-ethylenedioxythiophene], polyacetylene, polyparaphenylene, polyphenylenesulfide, polythiopene, polyelementophthalocyanine, and a copolymer thereof.

In the counter electrode for the dye-sensitized solar cell according to the present invention, it is preferable that a conductive polymer blend have an excellent affinity for an electrolyte, and include first and second polymers blended with each other in a weight ratio of 1 : 0.01 - 10. At this time, the first polymer is selected from the group consisting of poly(2-methoxy-5-(2'-ethylhexyloxy)-1,4-phenylenevinylene)-1,4-phenylenevinylene, polyaniline, polypyrrole, poly (3-tetradecylthiopene), poly(3,4-ethylenedioxythiopene), polyacetylene, polyparaphenylene, polyphenylenesulfide, polythiopene, polyelementophthalocyanine, and a copolymer thereof. Furthermore, the second polymer is selected from the group consisting of poly(ethylene oxide), poly(propylene oxide), poly(epichlorohydrin)-ethylene oxide, and a copolymer thereof.

In the counter electrode for the dye-sensitized solar cell according to the present invention, it is preferable that the platinum nanoparticles and inorganic oxide particles have a particle size of 10 - 1000 nm. More preferably, the particle size is 10 - 500 nm.

In the counter electrode for the dye-sensitized solar cell according to the present invention, it is preferable that the carbon compound, has a large reaction area, and be selected from the group consisting of carbon 60 ($C_{60}$) fullerene, carbon 70 ($C_{70}$) fullerene, carbon 76 ($C_{76}$) fullerene, carbon 78 ($C_{78}$) fullerene, and carbon 84 ($C_{84}$) fullerene.

In the counter electrode for the dye-sensitized solar cell according to the present invention, it is preferable that the inorganic oxide particles be selected from the group consisting of titanium oxide, indium oxide, tin oxide, indium-tin oxide, aluminum oxide, silicon oxide, and a mixture thereof.

Furthermore, the present invention provides a method of producing a counter electrode for a dye-sensitized solar cell, which comprises (1) positioning two counter electrodes in an electrophoretic cell such that the two counter electrodes are spaced from each other at a predetermined interval; (2) dispersing a conductive material, which is selected from the group consisting of a conductive polymer, platinum nanoparticles, a thin platinum film, a carbon compound, and inorganic oxide particles, and a conductive polymer blend, in an organic solvent; and (3) dipping the counter electrodes of the step (1) in a solution produced in the step (2) or dropping a solution, in which the conductive material is uniformly dispersed, in a predetermined amount onto the counter electrodes, depositing the conductive material of the step (2) on the counter electrodes using electrophoresis and spin coating/thermal decomposition processes, and drying the resulting counter electrodes, thereby completing a coating process.

In the counter electrode for the dye-sensitized solar cell according to the present invention, an electron transfer layer, which is capable of promoting smooth electron transfer through an interface between an electrolyte and the counter electrode, is laminated, and a specific surface area of the counter electrode increases. Thereby, electron transfer resistance is significantly reduced in comparison with a conventional counter electrode, resulting in significantly improved energy conversion efficiency of the dye-sensitized solar cell according to the present invention.

BRIEF DESCRIPTION OF THE DRAWINGS

The above and other objects, features and advantages of the present invention will be more clearly understood from the following detailed description taken in conjunction with the accompanying drawings, in which:

    FIG. 1 schematically illustrates operation of a conventional dye-sensitized solar cell;
    FIG. 2 schematically illustrates a dye-sensitized solar cell including a counter electrode according to the present invention; and
    FIGS. 3a to 3c are electron microscope images of surfaces of counter electrodes according to the present invention.

DESCRIPTION OF THE PREFERRED EMBODIMENTS

Hereinafter, a detailed description will be given of the present invention.

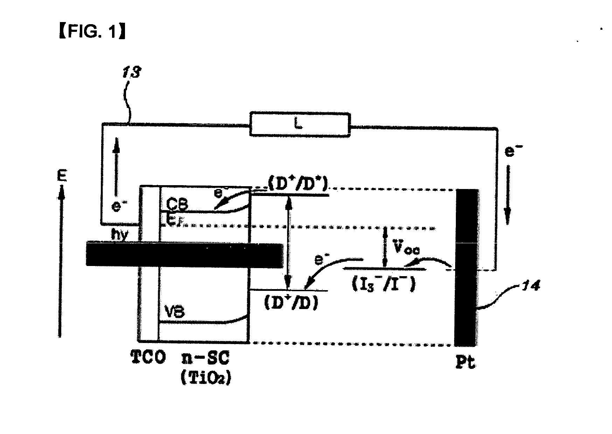

First, the operation of a dye-sensitized solar cell will be described with reference to FIG. 1.

When sunlight is irradiated on an n-type nanoparticle semiconductor oxide electrode which includes dye molecules (not shown) chemically adsorbed onto a surface thereof, an electronic transition of the dye molecules from a ground state ($D^+/D$) into an excited state ($D^+/D^*$) is initiated to form a pair of electron holes, and electrons in the excited state are introduced into a conduction band (CB) of semiconductor nanoparticles. The electrons, introduced into the semiconductor oxide electrode, are transferred through interfaces between the particles into a transparent conductive oxide (TCO) which is in contact with the semiconductor oxide electrode, and then moved through an external wire 13, connected to the transparent conductive oxide, to a counter electrode 14.

As described above, the dye molecules ($D^+/D^*$), which are oxidized due to the electronic transition caused by the light absorption, receive electrons ($e^-$), generated by the oxidation of iodine ions ($I_3^-/I^-$), in the redox electrolyte to be reduced, and $I^-$ ions are reduced by electrons ($e^-$), reaching the counter electrode, thereby completing the operation of the dye-sensitized solar cell.

A photocurrent is caused by diffusion of the electrons introduced into the semiconductor electrode, and a photovoltage ($V_{oc}$) is determined by a difference between Fermi energy (EF) of the semiconductor oxide and a redox potential of the electrolyte.

The present invention employs efficiently reduced electron transfer resistance between an electrolyte and an electrode and significantly improved light conversion efficiency that are caused by the lamination of a conductive material as an electron transfer layer, which is capable of providing a large reaction area to the counter electrode, on the counter electrode.

A conductive polymer, platinum nanoparticles, a carbon compound, or inorganic oxide particles may be coated with platinum, as the electron transfer layer, may be applied alone or in sequential combination on the counter electrode.

In this regard, the counter electrode may be an electrode made of a thin platinum film or a transparent conductive material, and in detail, it may be a conductive substrate selected from a conductive glass, a conductive flexible polymer sheet, or a platinum layer.

It is preferable that the conductive glass substrate or conductive flexible polymer sheet be a transparent substrate coated with conductive indium-tin oxide or fluorine-tin oxide. Furthermore, the conductive flexible polymer substrate may be a poly(ethylene terephthalate) sheet coated with indium-tin oxide or fluorine-tin oxide.

At this time, the conductive polymer, which has an excellent affinity for an electrolyte, is employed. Illustrative, but non-limiting, examples of the conductive polymer include poly[2-methoxy-5-(2'-ethylhexyloxy)-1,4-phenylenevinylene], polyaniline, polypyrrole, poly[3-tetradecylthiopene], poly[3,4-ethylenedioxythiopene], polyacetylene, polyparaphenylene, polyphenylenesulfide, polythiopene, polyelementophthalocyanine, and a copolymer thereof.

Furthermore, a conductive polymer blend, which has an excellent affinity for an electrolyte, is employed. With respect to this, it is preferable that the conductive polymer blend include a conductive polymer selected from the group consisting of poly(2-methoxy-5-(2'-ethylhexyloxy)-1,4-phenylenevinylene)-1,4-phenylenevinylene, polyaniline, polypyrrole, poly(3-tetradecylthiopene), poly(3,4-ethylendioxythiopene), polyacetylene, polyparaphenylene, polyphenylenesulfide, polythiopene, polyelementophthalocyanine, and a copolymer thereof, and another ion-conductive polymer selected from the group consisting of poly(ethylene oxide), poly(propylene oxide), poly(epichlorohydrin)-ethylene oxide, and a copolymer thereof. However, the ion-conductive polymers are not limited to the above examples. At this time, it is preferable that the polymers be blended with each other in a weight ratio of 1:0.01-10.

The polymer blend can be intermixed in a ratio of 10~50 wt% : 50~90 wt% between the former ion-conductive polymers. Also, the polymer blend can be intermixed in a ratio of 10~50 wt% : 50~90 wt% between the latter polymers.

The carbon compound provides a large reaction area, and is preferably selected from the group consisting of carbon 60 ($C_{60}$) fullerene, carbon 70 ($C_{70}$) fullerene, carbon 76 ($C_{76}$) fullerene, carbon 78 ($C_{78}$) fullerene, and carbon 84 ($C_{84}$) fullerene.

The inorganic oxide is firmly chemically adsorbed onto a surface of the platinum layer to stably coat the surface of the platinum layer. The inorganic oxide acts as a protective coat for protecting the platinum layer, and provides a significantly enlarged redox reaction area. Additionally, it increases property stability of the particles in the course of coating using electrophoresis or a heat treatment.

The inorganic oxide particles activate an electron transfer, and are preferably selected from the group consisting of titanium oxide, indium oxide, tin oxide, indium-tin oxide, aluminum oxide, silicon oxide, and a mixture thereof.

At this time, a size of the platinum nanoparticles in conjunction with the inorganic oxide particles is preferably controlled to be 10 - 1000 nm, and more preferably, 10 - 500 nm. When the size of the particle is less than 10 nm, a charge carrier peculiarly acts like a particle in a box in views of quantum mechanics, increasing a band interval. Additionally, since a band edge moves, high redox potentials are formed. When the size of the particle is more than 1000 nm, the electron transfer resistance between the electrolyte and electrode undesirably increases, disturbing smooth electron transfer.

When the conductive material constituting the electron transfer layer is applied to the counter electrode according to the present invention, the counter electrode assures a large reaction area, thereby efficiently reducing the electron transfer resistance between the electrolyte and electrode, resulting in significantly improved light conversion efficiency.

Hereinafter, a description will be given of the production of the counter electrode coated with the electron transfer layer according to the present invention.

First, two counter electrodes are positioned in an electrophoretic cell in such a way that they are spaced from each other at a predetermined interval (step 1). The counter electrodes are positioned opposite photoelectrodes each including a titanium oxide nanoparticle layer onto which a photosensitive dye is adsorbed.

Subsequently, the conductive material, which is selected from the group consisting of the conductive polymer, platinum nanoparticles, the carbon compound, and inorganic oxide particles, is dispersed in an organic solvent and spreaded uniformly (step 2).

It is preferable that the organic solvent be selected from the group consisting of methanol, ethanol, tetrahydrofuran, acetone, toluene, acetonitrile, and a mixture thereof.

It is preferable that the conductive material be controlled in an amount of 0.01 - 10 wt% based on the organic solvent. When the amount of the conductive material is less than 0.01 wt% based on the organic solvent, it is impossible to achieve significant electron transfer. When the amount is more than 10 wt%, flexibility is reduced due to high viscosity, and thus, adhesion to the counter electrodes as a coated base may be reduced.

Furthermore, in order to produce a polymer having an excellent affinity for the electrolyte, a polymer, which is selected from the group consisting of poly(2-methoxy-5-(2'-ethylhexyloxy)-1,4-phenylenevinylene)-1,4-phenylenevinylene, polyaniline, polypyrrole, poly(3-tetradecylthiopene), poly(3,4-ethylenedioxythiopene), polyacetylene, polyparaphenylene, polyphenylenesulfide, polythiopene, polyelementophthalocyanine, and a copolymer thereof, may be blended with another polymer, which is selected from the group consisting of poly(ethylene oxide), poly(propylene oxide), poly(epichlorohydrin)-ethylene oxide, and a copolymer thereof, in a weight ratio of 1:0.01-10, and then dispersed in the organic solvent. When the blending ratio deviates from the above range, an electron transfer promotion phenomenon undesirably fails to occur at a surface of the electrode of the present invention.

Next, after the counter electrodes are dipped in the solution, or a solution in which the conductive material is uniformly spreaded is dropped in a predetermined amount onto the counter electrodes, the conductive material is deposited on the counter electrodes, rinsed, dried, and subjected to a doping process and spin coating/thermal decomposition processes, thereby producing the counter electrodes of the present invention (step 3).

In this regard, the steps 1 to 3 are repeated once, twice, three times, or several times to form the electron transfer layer which consists of a conductive polymer layer, a platinum nanoparticle layer, a thin platinum layer, a carbon compound layer such as fullerene, an inorganic oxide particle layer, a conductive polymer blend layer, or a mixture thereof.
A more preferable structure of the counter electrode is as follows:

(1) a structure where the conductive polymer, as the electron transfer layer, is applied on the counter electrode;
(2) a structure where the platinum layer containing either nanoparticles or a thin film layer, as the electron transfer layer, are applied on the counter electrode;
(3) a structure where the platinum layer containing either nanoparticles or the thin film layer and conductive polymer, as the electron transfer layer, are sequentially applied on the counter electrode;
(4) a structure where the carbon compound, as the electron transfer layer is applied on the counter electrode;
(5) a structure where the carbon compound, and conductive polymer as the electron transfer layer are sequentially applied on the counter electrode;
(6) a structure where the carbon compound, and platinum nanoparticles, as the electron transfer layer, are sequentially applied on the counter electrode;
(7) a structure where the carbon compound, platinum nanoparticles, and conductive polymer, as the electron transfer layer, are sequentially applied on the counter electrode;
(8) a structure where the inorganic oxide particles and thin platinum layer, as the electron transfer layer, are sequentially applied on the counter electrode;
(9) a structure where the inorganic oxide particles, thin platinum layer, and conductive polymer, as the electron transfer layer, are sequentially applied on the counter electrode;
(10) a structure where the inorganic oxide particles and conductive polymer, as the electron transfer layer, are sequentially applied on the counter electrode;
(11) a structure where the conductive polymer blend, as the electron transfer layer, is applied on the counter electrode;
(12) a structure where the platinum nanoparticles and conductive polymer blend, as the electron transfer layer, are sequentially applied on the counter electrode;
(13) a structure where the carbon compound, and conductive polymer blend, as the electron transfer layer, are sequentially applied on the counter electrode;
(14) a structure where the carbon compound, platinum nanoparticles, and conductive polymer blend, as the electron transfer layer, are sequentially applied on the counter electrode; or
(15) a structure where the inorganic oxide particles, conductive polymer blend, and a platinum layer are sequentially applied on the thin platinum film.

In the method of producing the counter electrode for the dye-sensitized solar cell according to the present invention, the counter electrode of the step (1) may be a base in which a conductive glass substrate, a conductive flexible polymer substrate, or a platinum layer are applied on a conductive substrate.
In this case, it is preferable that the conductive glass substrate or conductive flexible polymer substrate be a transparent substrate coated with conductive indium-tin oxide or fluorine-tin oxide. Furthermore, the conductive flexible polymer substrate may be a poly(ethylene terephthalate) sheet coated with indium-tin oxide or fluorine-tin oxide.
As well, the counter electrode of the step (3) may be left in an iodine ($I_2$) atmosphere for 20 - 25 min, thereby creating an iodine-doped counter electrode. However, the type of dopant depends on the type of conductive polymer, and the dopant is not limited to iodine (e.g.: PEDOT:PSS).
The doping can be accomplished in a number of ways. One of the doping process can be comprised of: coating a substrate layer with conducting polymers; and doping the coating layer with dopants under the vapor phase atmosphere (e.g.: Poly(2-methoxy-5-(2'-ethyhexyloxy)-(1,4-phenylenevinylene) (MEH-PPV:$I_2$)).
The other doping process can be also carried out by coating a substrate with the admixture solution consisted of conducting polymers and dopants(acid) (e.g.: Poly(ethylenedioxythiopene)-poly(styrenesulfonate)(PEDOT:PSS)).
In addition, the doping can be accomplished by the following several ways: (a) Chemical Doping by Charge Transfer; (b) Electrochemical Doping; (c) Doping of Polyanilene by Acid-Base Chemistry; (d) Photodoping; (e) Charge Injection at a Metal-Semiconducting Polymer (Alan J. Heeger, J. Phys. Chem. B, Vol.105, No.36, 2001).
The counter electrode of the present invention functions to transfer electrons, which move through an external circuit, to a redox derivative. The counter electrode is suitable to constitute any type of dye-sensitized solar cell regardless of a phase (liquid, gel, or solid) of an electrolyte and the kind of redox ions (e.g. imidazolium iodide, or alkaline metal salt iodide). Furthermore, the counter electrode for the dye-sensitized solar cell according to the present invention promotes smooth electron transfer through an interface between the electrolyte, containing pairs of redox ions, and the counter electrode, thereby significantly improving the energy conversion efficiency of the dye-sensitized solar cell.
A method of producing the dye-sensitized solar cell including the highly efficient counter electrode according to the present invention comprises (1) dispersing oligomers in an organic solvent, adding an iodide salt to the oligomer solution, additionally dissolving iodine ($I_2$) in the resulting solution, and desolvating the organic solvent at a predetermined temperature for a predetermined time to produce an oligomer electrolyte, (2) casting the oligomer electrolyte onto a photoelectrode in which a photosensitive dye is adsorbed on a titanium oxide layer, (3) laminating the counter electrode, produced according to the present invention, on the oligomer electrolyte and pressing the resulting structure, and (4) attaching the photoelectrode and counter electrode to each other using an epoxy resin.

The solar cell produced through the above method according to the present invention has excellent light conversion efficiency in comparison with a conventional solar cell employing a counter electrode in which only a platinum layer is applied on a transparent conductive substrate.

Hereinafter, a description will be given of the present invention with reference to the drawings.

FIG. 1 illustrates the operation of a conventional dye-sensitized solar cell according to the present invention. As shown in FIG. 1, when sunlight is irradiated onto an n-type nanoparticle semiconductor oxide electrode which includes dye molecules (not shown) chemically adsorbed onto a surface thereof, an electronic transition of the dye molecules from a ground state ($D^+/D$) into an excited state ($D^+/D^*$) is initiated to form a pair of electron holes, and electrons in the excited state are introduced into a conduction band (CB) of semiconductor nanoparticles. The electrons, introduced into the semiconductor oxide electrode, are transferred through interfaces between the particles into a transparent conductive oxide (TCO) which is in contact with the semiconductor oxide electrode, and then moved through an external wire 13, connected to the transparent conducting oxide, to a counter electrode 14.

A redox electrolyte is introduced between the counter electrode 14 and the semiconductor oxide electrode, and a load (L) is connected to the transparent conductive oxide and counter electrode 14 in series to measure a short-circuit current ($J_{sc}$), an open-circuit voltage ($V_{oc}$), and a fill factor (FF), thereby evaluating efficiency of the solar cell.

The dye molecules ($D^+/D^*$), which are oxidized due to the electronic transition caused by the light absorption, receive electrons ($e^-$), generated by the oxidation of iodine ions ($I_3^-/I^-$), in the redox electrolyte to be reduced, and $I^-$ ions are reduced by electrons ($e^-$), reaching the counter electrode, thereby completing the operation of the dye-sensitized solar cell. A photocurrent is caused by the diffusion of the electrons introduced into the semiconductor electrode, and a photovoltage ($V_{oc}$) is determined by a difference between Fermi energy (EF) of the semiconductor oxide and a redox potential of the electrolyte.

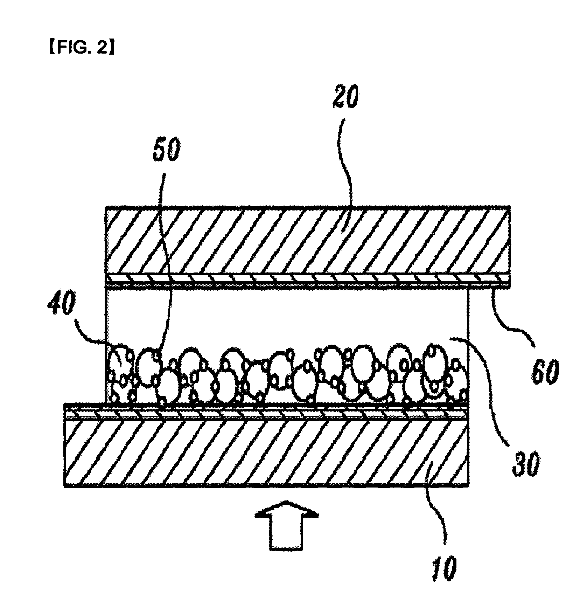

FIG. 2 illustrates the dye-sensitized solar cell including the counter electrode according to the present invention. The dye-sensitized solar cell of the present invention includes a photoelectrode 10, a counter electrode 20, and an electrolyte 30 interposed between them. The photoelectrode 10 is coated with semiconductor nanoparticles 40, and an organic dye 50 is adsorbed onto the semiconductor nanoparticles 40. The counter electrode 20 is coated with platinum 60, and positioned opposite the photoelectrode 10. The electrolyte 30 is interposed between the photoelectrode 10 and counter electrode 20. Furthermore, a conductive polymer as an electron transfer layer is applied on the counter electrode 20 coated with a base platinum layer. Alternatively, platinum nanoparticles are electrochemically applied on the counter electrode, or the platinum nanoparticles are electrochemically applied on the counter electrode and the conductive polymer is then laminated on the resulting counter electrode. Alternatively, inorganic oxide particles are electrochemically applied on the counter electrode and a platinum layer is then laminated on the resulting counter electrode (not shown).

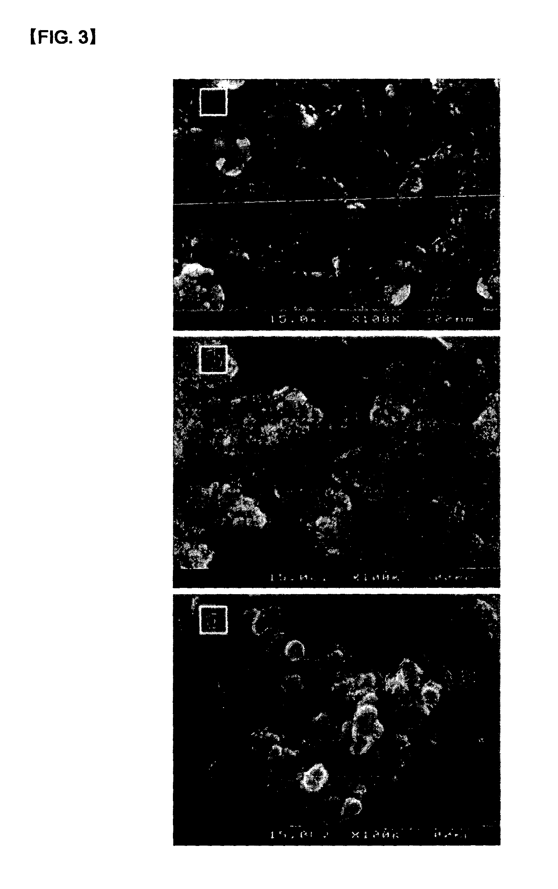

FIGS. 3a to 3c are FE-SEM (field emission scanning electron microscope) images of surfaces of the counter electrodes. The image (a) illustrates a $SnO_2$:F conductive glass surface coated with the base platinum layer, and the image (b) illustrates a surface of the conductive polymer which is laminated on the base platinum layer. As shown in the images, a conductive polymer thin layer is uniformly laminated on a surface of the platinum layer.

In the counter electrode for the dye-sensitized solar cell according to the present invention, a reaction area increases, the conductive polymer having an excellent affinity for the electrolyte is introduced to an interface between the electrolyte and a platinum catalyst, or the conductive polymer having an excellent affinity for the electrolyte is introduced to a surface of the counter electrode while the reaction area increases, resulting in smooth electron transfer through the interface between the electrolyte, containing pairs of redox ions, and counter electrode. Thereby, energy conversion efficiency of the dye-sensitized solar cell is significantly improved.

Accordingly, when the dye-sensitized solar cell is produced using the counter electrode for the dye-sensitized solar cell according to the present invention, the efficiency is significantly improved in comparison with a conventional dye-sensitized solar cell employing a counter electrode coated with only a platinum layer. Hence, the counter electrode for the dye-sensitized solar cell according to the present invention can be commercialized, and is very useful to produce a highly efficient and useful dye-sensitized solar cell.

Additionally, the highly efficient dye-sensitized solar cell employing the counter electrode of the present invention reduces the consumption of fossil fuel, which totally depends on imports and is used to generate electric power, resulting in reduced energy dependence on fossil fuels, thereby contributing to reduced pollution as a next generation clean energy source.

Having generally described this invention, a further understanding can be obtained by reference to certain specific examples and experimental examples which are provided herein for purposes of illustration only and are not intended to be limiting unless otherwise specified.

EXAMPLE 1

Production of a counter electrode, in which a conductive polymer is applied on the counter electrode, coated with a base platinum layer, to form an electron transfer layer

After the predetermined amount of $H_2PtCl_6$ solution (0.05 M in isopropanol) was dropped on a conductive substrate, the resulting substrate was subjected to a spin coating process (1st: 1000 rpm, 10 sec; and 2nd: 2000 rpm, 40 sec), heated from room temperature to 450°C for 2 hours, heat treated at 450°C for 20 min, and cooled to room temperature for 8 hours. Thereby, the application of a base platinum layer on the conductive substrate was completed. Hereinafter, a procedure of applying the base platinum layer on the conductive substrate will be conducted in the same manner. After the predetermined amount of conductive polymer solution dissolved in an organic solvent was dropped on a counter electrode, on which the base platinum layer is applied, a spin coating process (1st: 1000 rpm, 10 sec; and 2nd: 2000 rpm, 40 sec) was implemented, and a doping process was subsequently carried out.

EXAMPLE 2

Production of a counter electrode, in which platinum nanoparticles are electrochemically applied on the counter electrode, coated with a base platinum layer, to form an electron transfer layer

The two counter electrodes coated with the base platinum layer were positioned in an electrophoretic cell. In this regard, a distance between the two electrodes was maintained at 1 mm. The predetermined amount of platinum nanoparticles having a particle size of about 500 nm or less was put into a mixed solution of acetone/ethanol (1/1, v/v), and subjected to an ultrasonic treatment to be completely dispersed. A predetermined voltage was applied while the counter electrodes were completely dipped in the platinum nanoparticle solution, thereby inducing electrophoresis of the platinum particles. After the platinum nanoparticles were applied on the counter electrodes, they were heat treated (at 450°C for 20 min) to improve the contact between the platinum nanoparticles.

EXAMPLE 3

Production of a counter electrode, in which a platinum nanoparticle layer is electrochemically applied on the counter electrode, coated with a base platinum layer, and a conductive polymer layer is then laminated on the resulting counter electrode to form an electron transfer layer

A counter electrode, on which platinum nanoparticles were applied, was produced according to the same procedure as in example 2, and a conductive polymer was applied on the resulting counter electrode using a spin coating process and then subjected to a doping process according to the same procedure as example 1.

EXAMPLES 4 TO 6

Production of a counter electrode, in which a carbon compound layer is electrochemically applied on the counter electrode, coated with a base platinum layer, or in which the carbon compound layer is applied on the counter electrode and platinum particles or a conductive polymer is then laminated on the resulting counter electrode to form an electron transfer layer

The two counter electrodes coated with the base platinum layer were positioned in an electrophoretic cell as in example 2. The distance between the two electrodes was maintained at 1 mm. A predetermined amount of highly pure fullerene was dispersed in toluene, and then blended with a predetermined amount of acetonitrile solution. Subsequently, a predetermined voltage was applied for a predetermined time while the counter electrodes were completely immersed in the fullerene solution, thereby inducing electrophoresis of fullerene and deposition of fullerene on surfaces of the electrodes. After the counter electrodes were dried, the conductive polymer was applied on the dried counter electrodes using a spin coating process and then subjected to a doping process as in example 1, or alternatively, the dried counter electrodes were dipped in an $H_2PtCl_6$ aqueous solution and then electrochemically reduced to deposit the platinum particles on the fullerene surface.

EXAMPLES 7 TO 9

Production of a counter electrode, in which inorganic oxide particles are electrochemically laminated on the counter electrode, coated with a base platinum layer, and in which a platinum layer, a conductive polymer layer, or a platinum/conductive polymer layer is then laminated on the resulting counter electrode to form an electron transfer layer

The two counter electrodes coated with the base platinum layer were positioned in an electrophoretic cell as in example 2. The distance between the two electrodes was maintained at 1 mm. A predetermined amount of inorganic oxide nanoparticles (e.g. indium-tin oxide, ITO) was put into a mixed solution of acetone/ethanol (1/1, v/v) through the same procedure as in example 2, and subjected to an ultrasonic treatment to be completely dispersed. A predetermined voltage was applied while the counter electrodes were completely dipped in the inorganic oxide-dispersed solution, thereby inducing electrophoresis of the inorganic oxide particles. An $H_2PtCl_6$ solution (0.05 M in isopropanol) was dropped on the counter electrodes coated with the predetermined amount of inorganic oxide particles according to the same procedure as example 1 in which the base platinum layer was applied on the conductive substrate. The resulting counter electrodes were then subjected to a spin coating process ($1^{st}$: 1000 rpm, 10 sec; and $2^{nd}$: 2000 rpm, 40 sec), heated from room temperature to 450°C for 2 hours, heat treated at 450°C for 20 min, and cooled to room temperature for 8 hours. Thereby, the application of an inorganic oxide layer, coated with platinum, on the counter electrodes was completed.

EXAMPLE 10

Production of a dye-sensitized solar cell

1) Production of an electrolyte

An oligomer electrolyte, which had intermediate characteristics between a liquid electrolyte and a solid polymer electrolyte, was produced so as to evaluate the effect of a counter electrode of the present invention to light conversion efficiency of the dye-sensitized solar cell. 0.5 g of low molecular weight poly(ethyleneglycol dimethylether) (PEGDME, $M_n$ = 500 g/mol, Aldrich Co.) was dissolved in 4.5 g of acetonitrile (99.9 %, Aldrich Co.) to produce a homogeneous and transparent polymer solution (oligomer concentration of 10 wt%). Potassium iodide (KI, 99.998 %, Aldrich Co.) was added to the oligomer solution so that a molar ratio of [-O-]:[KI] was 20:1. An amount of added iodine ($I_2$) was fixed to 10 wt% based on potassium iodide. After potassium iodide and iodine were dissolved by agitation, acetonitrile as a solvent was completely volatilized at 50°C for a predetermined time to create the oligomer electrolyte containing no solvent.

2) Production of the dye-sensitized solar cell

After the oligomer electrolyte was cast on a photoelectrode, in which $Ru(dcbpy)_2(NCS)_2$ (Ru 535, Solaronix, Switzerland) as a photosensitive dye was adsorbed on a titanium oxide layer (thickness = 10 $\mu$m), the counter electrodes produced according to the five different procedures of the present invention, as described above, were laminated. In this regard, a 3M tape (thickness = 70 $\mu$m) was used as a gasket to prevent the photoelectrode and counter electrode from coming into contact with each other. The dye-sensitized solar cell was interposed between two glass substrates, and the glass substrates were fastened together using a clip. Subsequently, the photoelectrode and counter electrode were attached to each other using an epoxy resin, thereby completing the production of the dye-sensitized solar cell.

Evaluation of light conversion efficiency

An open-circuit voltage ($V_{OC}$), a short-circuit current ($J_{SC}$), a fill factor (FF), and energy conversion efficiency ($\eta$) of the solar cell of the solar cell were evaluated in an incidence light condition of 100 mW $cm^2$ using a potentiostat/galvanostat (263A, EG&G Princeton Applied Research, USA) and Xe lamp (50-500 W Xe lamp (Thermo Oriel Instruments, USA)). An effective area of the dye-sensitized solar cell was 0.125 $cm^2$. The open-circuit voltage ($V_{oc}$) is a potential difference formed at both ends of the solar cell when the solar cell is exposed to light while a circuit is opened, that is to say, the solar cell encounters infinite impedance. Just for reference, since a maximum value of $V_{oc}$ ($V_{max}$) depends on the band gap of a semiconductor, a relatively high $V_{oc}$ value can be gained by using a material having a high band gap. The short-circuit current ($J_{sc}$) is a current density of the solar cell when the solar cell is exposed to light while a circuit is shorted, that is to say, the solar cell has no external resistance. The short-circuit current depends on the intensity of incident light and wavelength distribution, but after these conditions are fixed, the value depends on how effectively electrons, which are excited by light absorption and re-combined with holes without dissipation, are transferred from an inside of the cell to an external circuit. At this time, dissipation caused by re-combination may occur inside a material or at interfaces between materials. The fill factor was calculated using the following Equation 1.

$$\text{Equation 1}$$

$$FF \quad = \quad \frac{V_{max} \bullet J_{max}}{V_{oc} \bullet J_{sc}}$$

The fill factor is obtained by dividing the product of current density and voltage ($V_{max} \times J_{max}$) at the maximum power point by the product of Voc and $J_{sc}$. Accordingly, the fill factor may be used as an index indicating how similar a shape of a current-voltage (J-V) curve is to a quadrangle when the solar cell is exposed to light.

The energy conversion efficiency ($\eta$) was calculated using the following Equation 2.

$$\text{Equation 2}$$

$$\eta \quad = \quad \frac{V_{max} \bullet J_{max}}{P_{in}} \times 100$$

The energy conversion efficiency ($\eta$) of the solar cell is a ratio of the maximum power, generated by the solar cell, to incident light energy ($P_{in}$).

Evaluation of electron transfer resistance of the counter electrode

The electron transfer resistance through an interface between an electrolyte and an electrode was evaluated using AC impedance analysis in order to estimate the electron transfer efficiency of the counter electrode of the present invention. The AC impedance analysis was conducted according to a method suggested by Hauch and Georg (A. Hauch and A. Georg. Electrochimica Acta 46, 3457, 2001). The oligomer electrolyte was interposed between two counter electrodes produced through the same procedure, and combined using an epoxy resin while the resulting structure was fastened together using a clip. 3M tape (thickness = 70 $\mu$m) was used as a gasket to prevent the two counter electrodes from coming into contact with each other, and an effective area of each counter electrode was 0.25 cm$^2$. Impedance was measured under conditions of potentiostat mode/500 mV amplitude using a ZAHNER IM6e impedance analyzer (Germany) within a frequency range of 0.1 - 100,000 Hz. The measurement results were plotted by a Nyquist plot or a Bode plot, and the electron transfer resistance was gained through an equivalent circuit analysis (i.e. R(C(RW)) or R(Q (RQ))) employing the measurement data.

EXPERIMENTAL EXAMPLE 1

A counter electrode was produced as in example 1. In the present experimental example, poly[2-methoxy-5-(2'-ethylhexyloxy)-1,4-phenylenevinylene] (MEH-PPV) as a conductive polymer was dissolved in a mixed organic solvent of methanol and tetrahydrofuran (8:2, weight ratio) in an amount of 0.1 wt%, and then subjected to a spin coating process on the counter electrode coated with platinum. Subsequently, the counter electrode coated with MEH-PPV/Pt was left in an iodine ($I_2$) atmosphere for 20 min to produce the iodine-doped counter electrode. A dye-sensitized solar cell was produced using the resulting counter electrode through the same procedure as in example 10 (sample 1).

Furthermore, poly[2-methoxy-5-(2'-ethylhexyloxy)-1,4-phenylenevinylene] (MEH-PPV) was mixed with poly (ethylene oxide) (PEO, $M_n$ = 1,000,000 g/mol, Aldrich Co.) in a weight ratio of 1 : 1, dissolved in a mixed organic solvent of methanol and tetrahydrofuran (8:2, weight ratio) in an amount of 0.1 wt%, and then subjected to a spin coating process on a counter electrode coated with platinum. Subsequently, the counter electrode coated with MEH-PPV/PEO/Pt was left in an iodine ($I_2$) atmosphere for 20 min to produce the iodine-doped counter electrode. A dye-sensitized solar cell was produced using the resulting counter electrode through the same procedure as in example 10 (sample 2).

As a comparative example, a counter electrode coated with only platinum was used to produce a dye-sensitized solar cell (sample 3).

FIGS. 3a to 3c are FE-SEM images of surfaces of the counter electrodes. The image (a) illustrates a SnO$_2$:F conductive glass surface coated with a base platinum layer, and the image (b) illustrates a surface of the conductive polymer which is laminated on the base platinum layer (sample 3). As shown in the images, a conductive polymer thin layer is uniformly laminated on a surface of a platinum layer.

Energy conversion efficiencies (light conversion efficiencies) of the dye-sensitized solar cells were evaluated at an incident light condition of 100 mW/cm$^2$. An open-circuit voltage, a short-circuit current, a fill factor, and energy conversion efficiency were measured in the same manner as the preceding examples, and electron transfer resistance (R$_{CT}$) was measured using AC impedance analysis. The results are described in Table 1.

TABLE 1

| Counter electrode | V$_{oc}$(V) | J$_{sc}$ (mA/cm$^2$) | FF(-) | η (%) | R$_{CT}$ (Ω cm$^2$) |
|---|---|---|---|---|---|
| Sample 1 (Pt/MEH-PPV) | 0.77 | 5.52 | 0.75 | 3.20 | 47.6 |
| Sample 2(Pt/MEH-PPV/PEO) | 0.76 | 7.71 | 0.66 | 3.84 | 30.7 |
| Sample 3(Pt) | 0.79 | 4.66 | 0.73 | 2.71 | 69.0 |

From Table 1, it can be seen that since the conductive polymer, that is, an electron transfer layer, is laminated on the counter electrode, the short-circuit current (J$_{sc}$) largely increases, resulting in significantly improved light conversion efficiency. Furthermore, if the electron transfer resistances (R$_{CT}$), calculated using the AC impedance analysis, are compared to each other, it can be seen that improvements in the short-circuit current and light conversion efficiency are caused by the reduced electron transfer resistance through an interface between the counter electrode and electrolyte. As well, it is observed that when the predetermined amount of PEO polymer is mixed with the conductive polymer, improvements in the short-circuit current and light conversion efficiency increase. The reason for this is believed to be that the PEO polymer mixed with the conductive polymer (MEH-PPV) improves adhesion strength between the conductive polymer and platinum layer and also the contact characteristics of the oligomer electrolyte.

EXPERIMENTAL EXAMPLE 2

A counter electrode was produced through example 2. In the present experimental example, the predetermined amount of platinum nanoparticles (Aldrich Co.) having a particle size of about 30 - 50 nm was put into 40 g of mixed solution of acetone/ethanol (1/1, v/v), and subjected to an ultrasonic treatment to be completely dispersed. 250 V of voltage was applied while the counter electrode was completely immersed in the platinum nanoparticle solution to conduct electrophoresis for 1 hour. After the electrophoresis, the counter electrode was separated from a cell, rinsed with a highly pure ethanol solution, and dried, thereby completing the production of the resulting counter electrode. A dye-sensitized solar cell was produced using the resulting counter electrode through the same procedure as example 10 (sample 4).

Furthermore, the counter electrode, on which the platinum nanoparticle layer was laminated, was heat treated at 450°C for 20 min. A dye-sensitized solar cell was produced using the resulting counter electrode through the same procedure as example 10 (sample 5).

As well, after two or three drops of dilute H$_2$PtCl$_6$ solution (0.01 M in isopropanol) fell onto the counter electrode, on which the platinum nanoparticle layer was laminated, the counter electrode was subjected to a spin coating process and then heat treated at 450°C for 20 min. A dye-sensitized solar cell was produced using the resulting counter electrode through the same procedure as in example 10 (sample 6).

As a comparative example, a counter electrode coated with only platinum was used to produce a dye-sensitized solar cell (sample 7).

FIGS. 3a to 3c are FE-SEM images of surfaces of the counter electrodes. The image (c) illustrates a surface of the platinum nanoparticle layer which is laminated on a base platinum layer according to the above procedure (sample 4).

Energy conversion efficiencies (light conversion efficiencies) of the dye-sensitized solar cells were evaluated at an incident light condition of 100 mW/cm$^2$. An open-circuit voltage, a short-circuit current, a fill factor, and energy conversion efficiency were measured in the same manner as the preceding examples, and the results are described in Table 2.

TABLE 2

| Counter electrode | V$_{oc}$(V) | J$_{sc}$ (mA/cm$^2$) | FF(-) | η (%) |
|---|---|---|---|---|
| Sample 4(Pt/Pt particle) | 0.64 | 9.95 | 0.48 | 3.07 |

Table continued

| Counter electrode | $V_{oc}$(V) | $J_{sc}$ (mA/cm$^2$) | FF(-) | $\eta$ (%) |
|---|---|---|---|---|
| Sample 5(Pt/Pt particle/thermal) | 0.66 | 10.87 | 0.49 | 3.52 |
| Sample 6(Pt/Pt particle /H$_2$PtCl$_6$/thermal) | 0.65 | 12.25 | 0.48 | 3.82 |
| Sample 7(Pt) | 0.63 | 9.06 | 0.42 | 2.38 |

From Table 2, it can be seen that when the platinum nanoparticle layer capable of providing a large reaction area is laminated on the counter electrode, the short-circuit current ($J_{SC}$) largely increases, resulting in significantly improved light conversion efficiency. Furthermore, since the heat treatment was conducted, or the heat treatment was conducted after the spin coating process using the dilute H$_2$PtCl$_6$ solution, contact between the platinum nanoparticles is improved.

EXPERIMENTAL EXAMPLE 3

A counter electrode was produced through example 3. In the present experimental example, the counter electrode was produced according to the same procedure as sample 5 in experimental example 2, and a conductive polymer layer was laminated according to the same procedure as sample 2 in experimental example 1. A dye-sensitized solar cell was produced using the resulting counter electrode through the same procedure as in example 10 (sample 8). Energy conversion efficiencies (light conversion efficiencies) of the dye-sensitized solar cells were evaluated at an incident light condition of 100 mW/cm$^2$. An open-circuit voltage, a short-circuit current, a fill factor, and energy conversion efficiency were measured in the same manner as in the preceding examples, and the results are described in Table 3.

TABLE 3

| Counter electrode | $V_{OC}$(V) | $J_{SC}$(mA/cm$^2$) | FF(-) | $\eta$(%) | $R_{CT}$($\Omega$ cm$^2$) |
|---|---|---|---|---|---|
| Sample 7(Pt) | 0.63 | 9.06 | 0.42 | 2.38 | 70.0 |
| Sample 8 (Pt/Pt particle/thermal/MEH-PPV/PEO | 0.57 | 14.23 | 0.46 | 3.75 | 11.6 |

From Table 3, it can be seen that since the platinum nanoparticle layer capable of providing a large reaction area is laminated on the counter electrode and the conductive polymer, that is, an electron transfer layer is then laminated on the resulting structure, the short-circuit current ($J_{SC}$) largely increases, resulting in significantly improved light conversion efficiency. Furthermore, if electron transfer resistances ($R_{CT}$), calculated using AC impedance analysis, are compared to each other, it can be seen that sample 8 has significantly reduced electron transfer resistance in comparison with samples 1 and 2. This means that when the reaction area of the counter electrode increases and interface resistance is reduced, the light conversion efficiency of the dye-sensitized solar cell is effectively improved.

EXPERIMENTAL EXAMPLE 4

Counter electrodes were produced through examples 4 to 6. In the present experimental example, fullerene C60 (SES Research, USA), that is, a carbon compound, was dispersed in toluene in a concentration of 1 mM (1.14 mL), and then blended with 40 mL of acetonitrile solution. Subsequently, 100 V of voltage was applied for 1 hour while the counter electrodes were completely dipped in the fullerene-dispersed solution, thereby inducing the electrophoresis of fullerene and deposition of fullerene on surfaces of the electrodes. After the counter electrodes were dried, the conductive polymer was applied on the dried counter electrodes using a spin coating process and then subjected to a doping process using iodine according to the same procedure as for sample 2 in experimental example 1. A dye-sensitized solar cell was produced using the resulting counter electrodes through the same procedure as example 10 (sample 9).

Furthermore, after fullerene was electrochemically applied according to the above procedure, the counter electrodes were dipped in a H$_2$PtCl$_6$ aqueous solution (0.1 M) and platinum particles were deposited on a surface of fullerene by an electrochemical reduction (-350 mV vs SCE). A dye-sensitized solar cell was produced using the resulting counter electrodes through the same procedure as example 10 (sample 10). Energy conversion efficiencies (light conversion efficiencies) of the dye-sensitized solar cells were evaluated at an incident light condition of 100 mW/cm$^2$. An open-circuit voltage, a short-circuit current, a fill factor, and energy conversion efficiency were measured in the same manner as in the preceding examples, and the results are described in Table 4.

TABLE 4

| Counter electrode | $V_{oc}$(V) | $J_{sc}$ (mA/cm$^2$) | FF(-) | η(%) |
|---|---|---|---|---|
| Sample 7(Pt) | 0.63 | 9.06 | 0.42 | 2.38 |
| Sample 9(Pt/C$_{60}$/MEH-PPV/PEO) | 0.65 | 13.13 | 0.45 | 3.84 |
| Sample 10 (Pt/C$_{60}$/H$_2$PtCl$_6$/thermal) | 0.66 | 12.98 | 0.44 | 3.77 |

From Table 4, it can be seen that since the carbon molecule (fullerene) layer capable of providing a large reaction area is laminated on the counter electrode and the conductive polymer or a platinum catalyst layer is then laminated on the resulting structure, the short-circuit current ($J_{sc}$) largely increases, resulting in significantly improved light conversion efficiency.

EXPERIMENTAL EXAMPLE 5

Counter electrodes were produced through examples 7 to 9. In a manner similar to example 2, 100 mg of indium-tin oxide (ITO) nanoparticles (Aldrich Co.) having a particle size of about 20 - 100 nm were put into 40 g of mixed solution of acetone/ethanol (1/1, v/v), and subjected to an ultrasonic treatment to be completely dispersed. 250 V of voltage was applied while the counter electrodes were completely immersed in the ITO nanoparticle solution to conduct electrophoresis for 1 hour.

Subsequently, after the counter electrodes were dried, two or three drops of dilute H$_2$PtCl$_6$ solution (0.05 M in isopropanol) fell onto the dried counter electrodes. The resulting counter electrodes were subjected to a spin coating process and then heat treated at 450°C for 20 min. A dye-sensitized solar cell was produced using the resulting counter electrodes through the same procedure as in example 10 (sample 11). Energy conversion efficiency (light conversion efficiency) of the dye-sensitized solar cell was evaluated at an incident light condition of 100 mW/cm$^2$. An open-circuit voltage, a short-circuit current, a fill factor, and energy conversion efficiency were measured in the same manner as in the preceding examples, and the results are described in Table 5.

TABLE 5

| Counter electrode | $V_{oc}$(V) | $J_{sc}$ (mA/cm$^2$) | FF(-) | η (%) |
|---|---|---|---|---|
| Sample 7(Pt) | 0.63 | 9.06 | 0.42 | 2.38 |
| Sample 11(Pt/ITO particle/H$_2$PtCl$_6$/thermal) | 0.66 | 10.85 | 0.46 | 3.29 |

From Table 5, it can be seen that since the ITO nanoparticle layer capable of providing a large reaction area is laminated on the counter electrode and a platinum catalyst layer is then laminated on the resulting structure, the short-circuit current ($J_{SC}$) greatly increases, resulting in the significantly improved light conversion efficiency.

As described above, when a dye-sensitized solar cell is produced using a counter electrode for the dye-sensitized solar cell of the present invention, unlike a conventional dye-sensitized solar cell employing a counter electrode coated with only a platinum layer, the reaction area increases, a conductive polymer having an excellent affinity for an electrolyte is introduced to an interface between the electrolyte and a platinum catalyst, or the conductive polymer having an excellent affinity for the electrolyte is introduced to a surface of the counter electrode while the reaction area increases, resulting in smooth electron transfer through the interface between the electrolyte, containing pairs of redox ions, and counter electrode. Thereby, the energy conversion efficiency of the dye-sensitized solar cell is significantly improved. Accordingly, the counter electrode for the dye-sensitized solar cell according to the present invention can be commercialized, and is very useful to produce a highly efficient and useful dye-sensitized solar cell.

The entire disclosure of Korean Patent Application No. 10-2004-0079402 filed on October 06, 2004 including specification, claims, drawings and summary are incorporated herein by reference in its entirety.

**Claims**

1. A counter electrode for a dye-sensitized solar cell **characterized by** that: the counter electrode is coated with an electron transfer layer which also acts as a reduction catalyst and comprises one or more conductive materials selected from the group consisting of a conductive polymer, platinum nanoparticles, a thin platinum film, a carbon compound, and inorganic oxide particles coated with platinum.

**2.** The counter electrode as set forth in claim 1, wherein the counter electrode is produced in such a way that:

the conductive polymer, as the electron transfer layer, is applied on a substrate;
the platinum layer containing either nanoparticles or thin film layer, as the electron transfer layer, are applied on a substrate;
the platinum layer containing either nanoparticles or a thin film layer and the conductive polymer, as the electron transfer layer, are sequentially applied on a substrate;
the carbon compound, as the electron transfer layer, is applied on a substrate;
the carbon compound, and the conductive polymer, as the electron transfer layer, are sequentially applied on a substrate;
the carbon compound, and platinum nanoparticles, as the electron transfer layer, are sequentially applied on a substrate;
the carbon compound, the platinum nanoparticles and the conductive polymer, as the electron transfer layer, are sequentially applied on a substrate;
the inorganic oxide particles and a thin platinum layer, as the electron transfer layer, are sequentially applied on a substrate;
the inorganic oxide particles, a thin platinum layer, and the conductive polymer, as the electron transfer layer, are sequentially applied on a substrate;
the inorganic oxide particles and the conductive polymer, as the electron transfer layer, are sequentially applied on a substrate;
a conductive polymer blend, as the electron transfer layer, is applied on a substrate;
the platinum nanoparticles and the conductive polymer blend, as the electron transfer layer, are sequentially applied on a substrate;
the carbon compound, and a conductive polymer blend, as the electron transfer layer, are sequentially applied on a substrate;
the carbon compound, the platinum nanoparticles, and a conductive polymer blend, as the electron transfer layer, are sequentially applied on a substrate; or
the inorganic oxide particles, the conductive polymer blend, and a platinum layer, as the electron transfer layer, on a substrate are sequentially applied on the thin platinum film.

**3.** The counter electrode as set forth in claim 1 or 2, wherein the conductive polymer has an excellent affinity for an electrolyte, and is selected from the group consisting of poly[2-methoxy-5-(2'-ethylhexyloxy)-1,4-phenylenevinylene], polyaniline, polypyrrole, poly[3-tetradecylthiopene], poly[3,4-ethylenedioxythiopene], polyacetylene, polyparaphenylene, polyphenylenesulfide, polythiopene, polyelementophthalocyanine, and a copolymer thereof.

**4.** The counter electrode as set forth in claim 2, wherein the conductive polymer blend has an excellent affinity for an electrolyte and includes first and second polymers blended with each other, the first polymer being selected from the group consisting of poly(2-methoxy-5-(2'-ethylhexyloxy)-1,4-phenylenevinylene)-1,4-phenylenevinylene, polyaniline, polypyrrole, poly(3-tetradecylthiopene), poly(3,4-ethylenedioxythiopene), polyacetylene, polyparaphenylene, polyphenylenesulfide, polythiopene, polyelementophthalocyanine, and a copolymer thereof, and the second polymer being selected from the group consisting of poly(ethylene oxide), poly(propylene oxide), poly(epichlorohydrin)-ethylene oxide, and a copolymer thereof.

**5.** The counter electrode as set forth in claim 4, wherein the polymer blend is inter-blended between the first polymers or the second polymers.

**6.** The counter electrode as set forth in claim 2, wherein the substrates are selected from a conductive glass or a conductive flexible polymer sheet.

**7.** The counter electrode as set forth in claim 6, wherein the conductive glass substrate and the conductive flexible polymer sheet are a transparent substrate coated with conductive indium-tin oxide or fluorine-tin oxide.

**8.** The counter electrode as set forth in claim 1 or 2, wherein the platinum nanoparticles and the inorganic oxide particles have a particle size of 10 - 1000 nm.

**9.** The counter electrode as set forth in claim 1 or 2, wherein the carbon compound, has a large reaction area, and is carbon 60 ($C_{60}$) fullerene, carbon 70 ($C_{70}$) fullerene, carbon 76 ($C_{76}$) fullerene, carbon 78 ($C_{78}$) fullerene, or carbon 84 ($C_{84}$) fullerene.

**10.** The counter electrode as set forth in claim 1 or 2, wherein the inorganic oxide particles are selected from the group consisting of titanium oxide, indium oxide, tin oxide, indium-tin oxide, aluminum oxide, silicon oxide, and a mixture thereof.

**11.** A method of producing a counter electrode for a dye-sensitized solar cell, comprising:

(1) positioning two counter electrodes in an electrophoretic cell such that the two counter electrodes are spaced from each other at a predetermined interval;
(2) dispersing a conductive material, which is selected from the group consisting of a conductive polymer, platinum nanoparticles, a carbon compound, and inorganic oxide particles, and a conductive polymer blend, in an organic solvent; and
(3) dipping the counter electrodes of the step (1) in a solution produced in the step (2) or dropping a solution, in which laminating particles are uniformly dispersed, in a predetermined amount onto the counter electrodes, depositing the conductive material of the step (2) on the counter electrodes using electrophoresis and spin coating/thermal decomposition processes, and drying the resulting counter electrodes, thereby completing a coating process.

**12.** The method as set forth in claim 11, further comprising repeating the steps (1) to (3) to form an electron transfer layer selected from the group consisting of a conductive polymer layer, a platinum nanoparticle layer, a thin platinum layer, a carbon compound layer, an inorganic oxide particle layer, and a conductive polymer blend layer, and a mixture thereof.

**13.** The method as set forth in claim 11 or 12, wherein each of the counter electrodes is produced in such a way that:

the conductive polymer, as the electron transfer layer, is applied on a substrate;
the platinum layer containing either nanoparticles or a thin film layer, as the electron transfer layer, are applied on a substrate;
the platinum layer containing either nanoparticles or the thin film layer and the conductive polymer, as the electron transfer layer, are sequentially applied on a substrate;
the carbon compound, as the electron transfer layer, is applied on a substrate;
the carbon compound, and the conductive polymer, as the electron transfer layer, are sequentially applied on a substrate;
the carbon compound, and the platinum nanoparticles, as the electron transfer layer, are sequentially applied on a substrate;
the carbon compound, the platinum nanoparticles, and the conductive polymer, as the electron transfer layer, are sequentially applied on a substrate;
the inorganic oxide particles and thin platinum film, as the electron transfer layer, are sequentially applied on a substrate;
the inorganic oxide particles, the thin platinum film, and the conductive polymer, as the electron transfer layer, are sequentially applied on a substrate;
the inorganic oxide particles and the conductive polymer, as the electron transfer layer, are sequentially applied on a substrate;
the conductive polymer blend, as the electron transfer layer, is applied on a substrate;
the platinum nanoparticles and the conductive polymer blend, as the electron transfer layer, are sequentially applied on a substrate;
the carbon compound, and the conductive polymer blend, as the electron transfer layer, are sequentially applied on a substrate;
the carbon compound, the platinum nanoparticles and the conductive polymer blend, as the electron transfer layer, are sequentially applied on a substrate; or
the inorganic oxide particles, the conductive polymer blend, and a platinum layer are sequentially applied on the thin platinum film.

**14.** The method as set forth in claim 11, wherein the organic solvent of the step (2) is methanol, ethanol, tetrahydrofuran, acetone, toluene, acetonitrile, or a mixture thereof.

**15.** The method as set forth in claim 11, wherein the conductive material of the step (2) is dispersed in an amount of 0.01 - 10 wt% based on the organic solvent.

**16.** The method as set forth in claim 11, wherein the conductive polymer has an excellent affinity for an electrolyte, and is selected from the group consisting of poly[2-methoxy-5-(2'-ethylhexyloxy)-1,4-phenylenevinylene], polyaniline, polypyrrole, poly[3-tetradecylthiopene], poly[3,4-ethylenedioxythiopene], polyacetylene, polyparaphenylene, polyphenylenesulfide, polythiopene, polyelementophthalocyanine, and a copolymer thereof.

**17.** The method as set forth in any one of claims 11 to 13, wherein the conductive polymer blend has an excellent affinity for an electrolyte, and includes first and second polymers blended with each other in a weight ratio of 1 : 0.01 - 10, the first polymer being selected from the group consisting of poly(2-methoxy-5-(2'-ethylhexyloxy)-1,4-phenylenevinylene)-1,4-phenylenevinylene, polyaniline, polypyrrole, poly (3-tetradecylthiopene), poly (3, 4-ethylenedioxythiopene), polyacetylene, polyparaphenylene, polyphenylenesulfide, polythiopene, polyelementophthalocyanine, and a copolymer thereof, and the second polymer being selected from the group consisting of poly(ethylene oxide), poly (propylene oxide), poly(epichlorohydrin)-ethylene oxide, and a copolymer thereof.

**18.** The method as set forth in claim 17, wherein the polymer blend is inter-blended between the first polymers or the second polymers in a ratio of 10~50wt% : 50~90wt%, respectively.

【FIG. 1】

【FIG. 2】

【FIG. 3】